# EUROPÄISCHE PATENTSCHRIFT

(11) **EP 0 960 956 B1**
(45) Veröffentlichungstag und Bekanntmachung des Hinweises auf die Patenterteilung: **04.07.2001**
(21) Anmeldenummer: 99107481.6
(22) Anmeldetag: 29.04.1999
(51) Int. Cl.: C23C 14/24, C23C 14/26

(54) **Verfahren zur Herstellung von keramischen Verdampferschiffchen**
Process for preparing ceramic evaporation boats
Procédé pour préparer des nacelles d'evaporation en céramique

(30) Priorität: 14.05.1998 DE 19821772
(43) Veröffentlichungstag der Anmeldung: 01.12.1999
(73) Patentinhaber: Elektroschmelzwerk Kempten GmbH, D-81737 München (DE)
(72) Erfinder: Seifert, Martin, 87437 Kempten (DE)
(74) Vertreter: Potten, Holger

(56) Entgegenhaltungen:
- DE-A- 3 114 467
- DE-B- 1 085 743
- DE-C- 19 516 233
- US-A- 2 996 412

## Beschreibung

Die Erfindung betrifft ein Verfahren zur Herstellung von keramischen Verdampferschiffchen mit verbessertem Erstbenetzungsverhalten.

Das gebräuchlichste Verfahren zum Beschichten von flexiblen Substraten mit Metallen, insbesondere mit Aluminium, ist die sog. Hochvakuum-Bandbedampfung. Das zu beschichtende Substrat wird über eine gekühlte Walze geführt und dabei dem Aluminiumdampf ausgesetzt, der sich auf der Substratoberfläche als dünne Metallschicht niederschlägt.

Zur Erzeugung des erforderlichen konstanten Dampfstromes werden keramische Verdampfer, sogenannte Verdampferschiffchen, im direkten Stromdurchgang auf etwa 1450°C erhitzt. Aluminiumdraht wird kontinuierlich zugeführt, auf der Keramikoberfläche verflüssigt und bei einem Vakuum von ca. 10⁻⁴ mbar verdampft. In Metallisierungsanlagen sind eine Reihe von Verdampferschiffchen so angeordnet, daß sich über die gesamte Breite des Substrates eine gleichmäßig dicke Aluminiumschicht niederschlägt.

Verdampferschiffchen bestehen in der Regel aus heißgepresstem Titandiborid (TiB₂) und Bornitrid (BN) und/oder Aluminiumnitrid (AlN). Bei solchen Verdampferschiffchen ist TiB₂ die elektrisch leitende Komponente, die es erlaubt, den Verdampfer wie einen ohmschen Widerstand aufzuheizen.

Eines der Hauptprobleme beim Betreiben von Bandbedampfungsanlagen ist die Erstbenetzung der Verdampferschiffchen mit dem zu bedampfenden Metall. In der Praxis ist sehr viel Erfahrung der Anlagenfahrer nötig, um die Erstbenetzung der Verdampferschiffchen optimal zu gestalten. So hat sich im englischsprachigen Raum der Begriff: "break in procedure" für das Erstbenetzen des Verdampferschiffchens eingebürgert, was die Kompliziertheit dieses Vorgangs veranschaulicht. So kann es beim "Anfahren" zu einer unvollständigen Benetzung der Kavität des Verdampfes kommen. Daraus resultieren vermehrte Ablagerungen an der der Drahtzuführung gegenüberliegenden Seite, die das Bedienungspersonal zwingen, die Verdampferschiffchen bei vorgegebener Abdampfrate zu "heiß zu fahren", d. h. sehr hoch zu erhitzen. Das führt zu einer drastischen Verkürzung der Lebensdauer der Verdampferschiffchen.
Weiter entspricht eine unvollständige Benetzung einer ungleichmäßigen Benetzung der Kavität des Verdampferschiffchens. Dadurch ist später kein gleichmäßiges, kontinuierliches Abdampfen des zu verdampfenden Metalls möglich. Dies zwingt das Bedienungspersonal dazu, ständig die Verdampferbeheizung zu regeln. Im Mittel wird dadurch der Verdampferschiffchen zu heiß gefahren. Dadurch wird, wie bereits ausgeführt die Lebensdauer der Verdampferschiffchen stark verkürzt.

Für sehr hochohmige Verdampferschiffchen, reicht die Spannung der Bedampfungsanlage in der Regel nicht aus, um sie auf Benetzungstemperatur aufzuheizen. Würde ein solches Verdampferschiffchen besser benetzen als herkömmliche Verdampferschiffchen, so findet auch bei nicht voll erreichter Benetzungstemperatur eine Anfangsbenetzung statt. Dadurch wird das System Verdampferschiffchen/Aluminiumbad niederohmiger. Dies bewirkt sofort einen größeren Stromfluß, was wiederum zu einer besseren Erhitzung des Verdampferschiffchens und in folge damit auch zu einer nochmals verbesserten Benetzung führt.

Auch das Problem der Widerstandsstreuung von Verdampferschiffchen zu Verdampferschiffchen wird dadurch wesentlich unkritischer und es kommt nicht zum Stillstand der Bedampfungsanlagen wegen höherohmiger Verdampferschiffchen.

Je besser das Verdampfermaterial durch das zu verdampfende Metall benetzbar ist, desto geringer ist die Gefahr, das Verdampferschiffchen zu überhitzen und damit die Lebensdauer des Verdampferschiffchens drastisch zu verringern. Außerdem führt gutes Benetzen zu optimaler Badausbildung des Metalls in der Kavität des Verdampferschiffchens und damit zu verbesserten Abdampfbedingungen und gleichmäßigerer Belastung des Verdampferschiffchens was wiederum die Lebensdauer des Verdampferschiffchens verlängert.

DE-C-195 16 233 offenbart Verfahren zur Beschichtung von Verdampferschiffen, die zu einer Verbesserung der Benetzbarkeit führen. Mehrere verschiedene Komponenten kommen für die Beschichtung in Frage, darunter Komponenten, die gleichzeitig Komponenten des keramischen Materials sein können.

Dokument DE-B-1 085 743 offenbart Verdampfungstiegel, die mittels eines Schmelzprozesses hergestellt werden. Für das Schmelzen der Boride wird Elektronenbombardement angewendet.

Die Erfindung betrifft ein Verfahren gemäß Anspruch 1.
Die Verfahrensführung erfolgt vorzugsweise dergestalt, daß der Gehalt an leitender Komponente an der Oberfläche des Verdampferschiffchens, von der die Verdampfung des Metalls erfolgt relativ mindestens zwei % höher ist als im übrigen Material des Verdampferschiffchens.

Besonders bevorzugt erfolgt sie dergestalt, daß sich auf der Oberfläche des Verdampferschiffchens, von der die Verdampfung des Metalls erfolgt, eine Schicht der leitenden Komponente des keramischen Materials befindet.

Die Schicht aus der elektrisch leitenden Komponente sollte vorzugsweise zum übrigen Verdampfermaterial elektrischen Kontakt haben. Dadurch wird diese Schicht selbst elektrisch leitend und auf Grund des geringen spezifischen Widerstands des Materials heißer als das übrige Verdampfermaterial. Dies führt nochmals zu einer Verbesserung der Benetzbarkeit der Oberfläche des Verdampfers.

Vorzugsweise erfolgt die Anreicherung der elektrisch leitenden Komponente auf der Oberfläche des Verdampferschiffchens ausgehend von einem im Stand der Technik bekannten Verdampferschiffchen mittels eines der im folgenden genannten Verfahren:
1) Die Oberfläche des Verdampferschiffchens von der die Verdampfung des Metalls im bestimmungsgemäßen Betrieb erfolgen soll wird mit Hilfe eines energiereichen Laserstrahls derart erhitzt, daß die nicht elektrisch leitenden Komponenten [in der Regel BN (Schmelzpunkt: 2300°C) und AlN (Schmelzpunkt:
   2300°C)] verdampfen und gleichzeitig die elektrisch leitende Komponente [in der Regel TiB₂ (Schmelzpunkt: 2900°C)] nur geschmolzen wird. Der Energiegehalt des energiereichen Laserstrahls ist daher vorzugsweise so zu wählen, daß er die Oberfläche des Verdampferschiffchens auf mehr als 2900 °C aber nicht weniger als 2700 °C erhitzt. Nach der Abkühlung erhält man dadurch eine an elektrisch leitender keramischer Komponente (in der Regel TiB₂) angereicherte Schicht auf der Oberfläche des Verdampferschiffchens. Bei kürzerem Erhitzen erhält man eine weniger an elektrisch leitender keramischer Komponente angereicherte Schicht auf der Oberfläche des Verdampferschiffchens.
2) Auf die Oberfläche des Verdampferschiffchens wird Pulver, welches die elektrisch leitende keramische Komponente enthält, aufgebracht und mit einem energiereichen Laserstrahl so aufgeschweißt, daß eine elektrisch leitende Schicht aus dem elektrisch leitenden keramischen Material entsteht. Dies kann beispielsweise für TiB₂ als elektrisch leitende keramische Komponente analog einer an sich bekannten Pulverbeschichtung mit TiB₂ erfolgen.
3) Pulver enthaltend die elektrisch leitende keramische Komponente wird mit einem organischen oder anorganischen Binder zu einer Paste verarbeitet und diese Paste auf die Oberfläche des Verdampferschiffchens aufgestrichen. Der Binder ist derart ausgewählt, daß er während des Aufheizens des Verdampferschiffchens verdampft. Beim Aufheizen des Verdampferschiffchens verdampft daher der Binder und es entsteht die gewünschte elektrisch leitende Schicht, die anschließend mit Aluminium benetzt werden kann.
   Als Binder kann beispielsweise Glyzerin eingesetzt werden. Diese Schicht wird zusätzlich ebenfalls wie in 2) beschrieben mittels eines energiereichen Laserstrahls behandelt um einen besseren Kontakt der elektrisch leitenden Schicht zum übrigen Verdampfermaterial zu realisieren.

Im Regelfall handelt es sich bei der elektrisch leitenden Komponente des keramischen Materials um TiB₂.

Als Pulver enthaltend die elektrisch leitende keramische Komponente wird daher im Regelfall TiB₂-haltiges Pulver eingesetzt. Vorzugsweise wird TiB₂ Pulver eingesetzt.

Als energiereicher Strahl wird der Strahl eines Lasers verwenden. Als Laser kann beispielsweise ein Gas- Festkörper- oder Halbleiterlaser verwendet werden.

Vorzugsweise erfolgt das Erhitzen der Oberfläche des keramischen Verdampferschiffchens durch einen energiereichen Strahl unter Inertgasbedingungen. Beispiele für Inertgase sind Helium oder Argon.

Die erfindungsgemäß hergestellten Verdampferschiffchen haben gegenüber bekannten Verdampferschiffchen folgende Vorteile:
1) Sie zeigen von Einsatzbeginn an eine gute, gleichmäßige Benetzung, die zu einer zeitlich und räumlich spritzerarmen konstanten Abdampfrate führt.
2) Sie "laufen" von Anfang an konstant und müssen nicht ständig nachgeregelt werden.
3) Die Widerstandstreuung der Verdampferschiffchen, die aus der kaum vermeidbaren Widerstandsstreuung im Sinterkörper, aus dem die Verdampferschiffchen hergestellt werden, resultiert, macht sich nicht in der Form negativ bemerkbar, daß die hochohmigeren Verdampferschiffchen nicht mehr benetzbar sind und die Bedampfungsanlagen deswegen gestoppt werden müssen.

Die folgenden Beispiele dienen der weiteren Erläuterung der Erfindung.

### Beispiel 1: Erfindungsgemäße Herstellung eines Verdampferschiffchens

Die Oberfläche eines Verdampferschiffchens von der die Metallverdampfung erfolgen soll mit den Maßen 10*20*120 mm hergestellt aus einem keramischen Material bestehend aus 47,5 Gew. % TiB₂ und 52,5 Gew. % BN wurde durch einen YAG-Laser (Wellenlänge = 1,06 µm / Strahldurchmesser = mm / Leistung = 100 W) in mehrere Spuren (80 mm lang) in einem Argonstrom bestrahlt.

### Beispiel 2: Erfindungsgemäße Herstellung eines Verdampferschiffchens

In die Oberfläche eines Verdampferschiffchens von der die Metallverdampfung erfolgen soll (10*20*120 mm / 47,5 Gew. % TiB₂ und 52,5 Gew. % BN) wurden etwa 0,5 mm tiefe Rillen mechanisch eingekratzt. In diese Rillen wurde TiB₂-Pulver gestreut. Dieses Pulver wurde, wie in Beispiel 1 beschrieben, mit einem YAG-Laser bestrahlt. Anschließend wurden die noch verbliebenen Pulverreste mit Druckluft abgeblasen.

### Beispiel 3: Vergleich der erfindungsgemäß hergestellten Verdampferschiffchen mit einem bekannten Verdampferschiffchen

Aus der gleichen Sintercharge (47,5 Gew. % TiB₂ und 52,5 Gew. % BN) aus der die in den Beispielen 1 und 2 behandelte Verdampferschiffchen hergestellt wurden, wurde ein weiteres Verdampferschiffchen mit den gleichen Maßen wie beschrieben als Vergleichs-Verdampferschiffchen hergestellt.

Dieses Vergleichs-Verdampferschiffchen sowie die in den Beispielen 1 und 2 hergestellten Verdampferschiffchen wurden unter definierten Bedingungen verglichen.

Die Verdampfer wurden stirnseitig eingespannt, vor dem Aufheizen wurden 2 g Al-Draht auf die Mitte der Oberfläche des Verdampferschiffchens von der die Metallverdampfung erfolgen soll gelegt. Ein Vakuum von < 1*10⁻⁴ mbar wurde angelegt. Die Verdampferschiffchen wurden in diesem Hochvakuum linear in 10 min auf eine Leistung von 3,96 KW durch einen Software-Regelkreis aufgeheizt ("PowerRamping").

An den Stirnseiten der Verdampfer wurde dabei direkt die Verdampferspannung gemessen. Gleichzeitig wurde an anderer Stelle im Stromkreis der Stromfluß durch das Verdampferschiffchen gemessen. Die Meßwerte für Spannung und Strom wurden in Sekundenabständen aufgezeichnet. Sie standen nach dem Versuch als Datenfile zur Verfügung.

Die Benetzung der Verdampferoberfläche durch das Aluminium zeigte sich generell im überproportionalen Anstieg des Stromflusses bei einer bestimmten Leistung im Vergleich zum Anstieg des Stromflusses bei einem Verdampfer ohne Aluminiumauflage, da gegenüber einem solchen Verdampfer das benetzende Aluminium einen zusätzlichen Stromfluß ermöglicht.

Rechnet man die Heizleistung, bei der dieser Anstieg des Stromflusses erfolgt, auf die glühende Oberfläche um, so kommt man auf eine Benetzungsleistung pro glühende Fläche von 44W/cm² für das Vergleichs-Verdampferschiffchen sowie von < 40W/cm² für die Verdampferschiffchen aus den Beispielen 1 und 2 ermittelt.

Dies Ergebnis belegt, daß die erfindungsgemäß hergestellten Verdampferschiffchen bei niedrigeren Temperaturen benetzt wurden als das Vergleiches-Verdampferschiffchen und somit ein verbessertes Erstbenetzungsverhalten als bekannte Verdampfer besitzen.

## Patentansprüche

1. Verfahren zur Herstellung von Verdampferschiffchen aus keramischem Material zum Verdampfen von Metall umfassend elektrisch leitende Komponente und elektrisch nicht leitende Komponente, dadurch gekennzeichnet, daß die Oberfläche eines an sich bekannten Verdampferschiffchens von der die Verdampfung des Metalls im bestimmungsgemäßen Betrieb erfolgt mit Hilfe eines energiereichen Strahls derart erhitzt wird, daß die elektrisch nicht leitenden Komponenten des Verdampferschiffchens verdampfen und gleichzeitig die elektrisch leitende Komponente des Verdampferschiffchens nur geschmolzen wird, wobei als energiereicher Strahl der Strahl eines Lasers verwendet wird.

## Claims

1. Process for producing vaporisation boats from ceramic material for the vaporisation of metal comprising an electrically conductive component and an electrically nonconductive component, characterized in that the surface of a vaporisation boat known per se from which the vaporisation of the metal occurs in normal operation is heated by means of a high-energy beam so that the electrically nonconductive components of the vaporisation boat vaporise and at the same time the electrically conductive component of the vaporisation boat is only melted, the high-energy beam used being a laser beam.

## Revendications

1. Procédé de production de nacelles de vaporisation en matière céramique pour la vaporisation de métal, comprenant un composant conducteur de l'électricité et un composant non conducteur de l'électricité, caractérisé en ce que la surface d'une nacelle de vaporisation connue en soi depuis laquelle la vaporisation du métal a lieu en fonctionnement conforme aux spécifications, est chauffée au moyen d'un faisceau de haute énergie de telle sorte que les composants non conducteurs de l'électricité de la nacelle de vaporisation se vaporisent et qu'en même temps, le composant conducteur de l'électricité de la nacelle de vaporisation ne soit que fondu, le faisceau de haute énergie utilisé étant le faisceau d'un laser.
